# EUROPEAN PATENT SPECIFICATION

(11) **EP 1 693 877 B1**
(45) Date of publication and mention of the grant of the patent: **13.04.2011**
(21) Application number: 05450024.4
(22) Date of filing: 10.02.2005
(51) Int. Cl.: H01J 27/02, H01J 37/08

(54) **High current density ion source**
Ionenquelle mit hoher Stromdichte
Source d'ions à densité de courant élevée

(43) Date of publication of application: 23.08.2006
(73) Proprietor: The Thailand Research Fund, Bangkok 10400 (TH)
(72) Inventor: Wirojana, Tantraporn, Faculty of Science, Ladkrabang Bangkok 10520 (TH)
(74) Representative: Patentanwaltskanzlei Matschnig & Forsthuber OG

(56) References cited:
- DE-A1- 2 263 478
- US-A1- 2002 000 779
- US-A1- 2002 084 180
- PATENT ABSTRACTS OF JAPAN vol. 1997, no. 12, 25 December 1997 (1997-12-25) -& JP 09 223594 A (EBARA CORP), 26 August 1997 (1997-08-26)
- ANDERS ANDRÉ ET AL.: "Hollow-anode plasma source for molecular beam epitaxy of gallium nitride" REVIEW OF SCIENTIFIC INSTRUMENTS, vol. 67, no. 3, March 1996 (1996-03), pages 905-907, XP002335373 American Institute of Physics, US
- ANDERS ANDRÉ ET AL: "Characterization of a low-energy constricted-plasma sourcea)" REVIEW OF SCIENTIFIC INSTRUMENTS, AMERICAN INSTITUTE OF PHYSICS, US, vol. 69, no. 3, March 1998 (1998-03), pages 1340-1343, XP012036456 ISSN: 0034-6748
- SHERMAN A: "BRIEF REPORT AND COMMENT" JOURNAL OF VACUUM SCIENCE AND TECHNOLOGY: PART B, AMERICAN INSTITUTE OF PHYSICS. NEW YORK, US, vol. 8, no. 4, 1 July 1990 (1990-07-01), pages 656-657, XP000358583 ISSN: 1071-1023

## Description

### Objective of the Invention:

The objective of the invention is to provide a high current density ion beam with a low total power consumption (less than 50 watt) and in which the ion flux will be initially of low kinetic energy and with low energy spread. The beam source requires no magnetic confinement nor water cooling, comprising instead the following 1) A microwave source of 2.45 GHz frequency to ignite a plasma (ions and electrons) in the source gas, 2) A "DC" voltage source to initiate and maintain the avalanche multiplication with in the gas, 3) A cathode electrode that can yield secondary electrons upon arrival of the ion current and 4) A vacuum external to the gas plasma source of the order of 10⁻⁴ mbar or lower.

The resulted high current density ion flux also makes use of the pressure gradient between the plasma chamber (inside pressure 10^{-1±1} mbar) and the enclosing vacuum chamber (≤10⁻⁴ mbar). The ions in the cathode side space-charge layer (where the slope of the relation of the electric field and distance in non-zero, i.e. dE/dx ≠ 0) are driven not only by the electric field but also by the higher pressure in the plasma chamber through a small orifice to the lower pressure in the enclosing vacuum chamber with nearly the speed of sound. The current density of the ion beam can be several amperes per square centimeter (A/cm²) with the high quality beam wherein the initial kinetic energy of ion beam is less than 50 electron volts (eV) and the attendant smaller energy spread.

### Field of the Invention:

This invention relates to plasma physics.

### Prior Art:

Conventional DC ion sources have long been known to find applications in semiconductor processing. A typical source may comprise a plasma system to produce the desired ions and an extraction/focusing system using high voltage to extract the ion beam from the plasma. The beam then needs to be focused or formed into a parallel beam. The plasma may be produced in a plasma chamber by ionization of the gas under high DC or RF electric field, and the ions in plasma are drawn by high dc electric field from extraction system to the focusing system.

High current density ion sources generally are needed in etching applications, ion implantation and in accelerator technology. In order to provide the high current density ion beam, it is necessary that the gas must be of sufficiently high density in order to provide the high-density conduction charge carriers (electrons and ions). Usually the plasma is created by ionization of the gas by an external RF field. To yield the high-density plasma, a high-energy external RF source is required. However, eventually the plasma density will reach saturation regardless of the increased external RF field.

US 2002/0000779 A1 describes the methods for producing a linear array of streaming flux of plasma with low energy ions and electrons, to synthesize atomic thin crystal-like thin films on the surface of substrate. The plasma flux in US 2002/0000779 A1 is suitable for a large cross section area deposition process that does not necessarily need a very high density plasma source.

DE 2263 478 A1 describes an arrangement for generating ions, wherein a straight channel electron multiplier fed by an electric voltage is operated in presence of a gas producing the desired ions upon ionization and the ions emitted from the channel electron multiplier thereupon are used as ion beam; the two ends of the discharge channel open into separate spaces between which a partial pressure gradient is maintained with regard to the gas producing the ions.

Other ion sources based on a plasma discharge with a pressure gradient are disclosed in US 2002/0084180 and by A. Sherman in J. Vac. Sci. & Technol. B 8 (1990) pp.656-657.

JP 09/223594 A discloses a beam source with a discharge vessel fed by a DC voltage and a high frequency power supply via a coil would around a discharge vessel.

A. Anders et al., in Rev. Sci. Instrum. 67 (3), March 1996 pp.905-907 describe a hollow-anode plasma source for molecular beam epitaxy of gallium nitride, employing a special form of glow discharge with very small anode area, wherein driven by a pressure gradient, the plasma forms a bright plasma jet streaming with supersonic velocity towards the substrate. A similar device is described by A. Anders et al., in Rev. Sci. Instrum. 69(3), March 1998 pp.1340-1343.

### Summary of the invention:

The invention is distinct over the prior art by providing the features as described in claim 1 to overcome the problems of prior art discussed below.

The high-energy external field to ionize and produce the high-density plasma also produces heat within the system. As the temperature of system rises, the efficiency of system becomes lower. Therefore, the conventional source needs a cooling system (air or water-cooling). Most high current density ion sources will also employs magnetic fields for the purpose of exciting and maintaining the plasma, but the main purpose of the magnetic fields is to confine the plasma flow within the system not to come into contact with the internal surface of the plasma chamber. The magnetic field will force the conduction charge carriers (electron and ions) in the plasma into circular orbit to reduce the fraction of the plasma which otherwise would hit the internal surface of plasma chamber in order to reduce the need for the cooling of the chamber, as well as to prevent contamination within the plasma. However, the temperature of the plasma itself is actually increased.

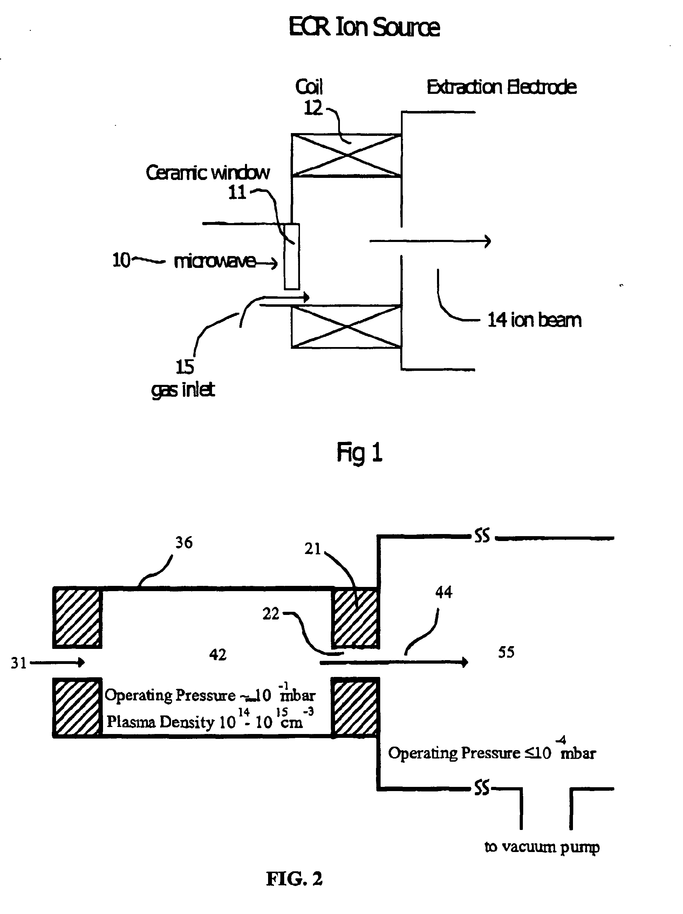

For the mentioned characteristic of the available high current density ion sources, the following are common 1) the external field energy (RF) and magnetic field are used, for ionizing the gas and confining the plasma; 2) A cooling system to dissipate the temperature of the system; and 3) An extraction system comprising a high DC electric field to extract the ions from the plasma to produce the ion beam. Beside gaining high energy from of the high external field which ionizes the gas, the ions within the plasma also gain the energy from the high-energy extraction field. The magnetic field also causes the conduction charge carriers to move into spiral around the magnetic field line. So the ions in the beam will have high kinetic energy spread due to both the high electric fields mentioned above and the lateral velocity spread due to the magnetic field, making it difficult for subsequent focusing. An example of the conventional ion source that has the characteristics like the source as mentioned above is the Electron Cyclotron Resonance (ECR) ion source as shown in FIG 1. The ECR ion source necessarily operates with a high magnetic field to fulfill the resonance condition of the microwave frequency and electron cyclotron frequency. The microwave power enters a cavity through a cylindrical waveguide and ceramic window to ionize the gas. The standard microwave frequency of 2.45 GHz is used, leading to a required magnetic field of 0.0875 tesla to confine the plasma. In addition a high DC electric potential is used to extract the ion beam. Hence the ion beam has a large energy spread. In addition, in order to produce a plasma with the ECR method it is necessary to provide a long collision mean free path which hence limits the pressure in the plasma chamber to be < 10⁻³ mbar. At the low pressure, the ion current density will be limited by the available number of gas atoms per cubic centimeter (cm⁻³) in the plasma source. Hence the magnetically confined and the ECR types of ion source cannot provide high ion beam intensity.

### Brief Description of the Drawings:

Fig. 1 is a construction of the Electron Cyclotron Resonance (ECR) Ion Source;
Fig. 2 shows the technical approach of the high current density microwave- initiated ion source by using a small cross section ion beam driven by higher pressure in the plasma chamber through a small orifice to the lower pressure chamber.
Fig. 3A shows the construction of the high current density microwave-initiated ion source of 2.45 GHz frequency.
Fig. 3B shows a cross sectional schematic view of the high current density microwave-initiated ion source of 2.45 GHz Frequency.
Fig. 4 shows the mechanism of the avalanche multiplication of the high current density microwave-initiated ion source.
Fig. 5 shows the theoretical relationship between current and voltage of the high-density microwave plasma source.
Fig. 6 shows the experimental relationship between current and voltage of the high-density microwave-initiated plasma source for 30, 40 and 50 watts microwave power.
Fig.7 shows the experimental relationship between ion current density and anode-cathode voltage of the high current density microwave-initiated ion source for 30, 40 and 50 watts microwave power.

### Detailed Description of the Invention

In making a high current density ion beam of high quality, which means a high current density ion beam, but having low divergence and low energy spread, the controlling factor of the quality of ion beam are the nature of plasma source and extraction system. This invention is a "DC" ion source using the microwave as the initial energizer to yield plasma with good spatial uniformity and high brightness. This invention can produce the high current density ion beam which can be easily focused and scanned, and which can be used to etch or implant the material for desired pattern with rapid etching or implanting rate.

**FIG.2** shows an electrode **21**, which is called in this invention the plasma electrode, is installed between plasma chamber **36** and vacuum chamber 55. In the electrode **21** a small orifice **22,** called the ion exit hole, serves as the exit of plasma beam **44** from the plasma source **42** to the vacuum chamber **55**. The ion exit hole **22** serves to cause a pressure gradient between the plasma chamber **36** and the vacuum chamber **55**. A smaller diameter of ion exit hole will cause a larger pressure gradient. The vacuum chamber **55** and the plasma chamber **36** can be controlled by balancing the gas flow through the small ion exit hole **22,** while the plasma chamber is also slowly fed by a desired gas such as Argon to maintain the pressure inside the plasma chamber to be in the range of 10⁻¹ mbar, so that the gas density will be of the order of 10¹⁴-10¹⁵ cm⁻³.

By whatever methods for plasma ionization, at 0.1 mbar plasma from the plasma source **42** will be produced in the plasma chamber **36** to yield the plasma density of the order of 10¹⁴-10¹⁵ cm⁻³. The plasma will be driven by the pressure difference through the ion exit hole **22** as a hydrodynamic streamline flow of the fluid. At the exit speed of plasma beam can be about the speed of sound, about 10⁶ centimeter per second (cm/sec) without the help of any extraction electric field. If the beam is an ion beam, but without the influence of an extraction electric field, the ion beam will be a low-energy ion beam that can be accelerated, focused and scanned easily.

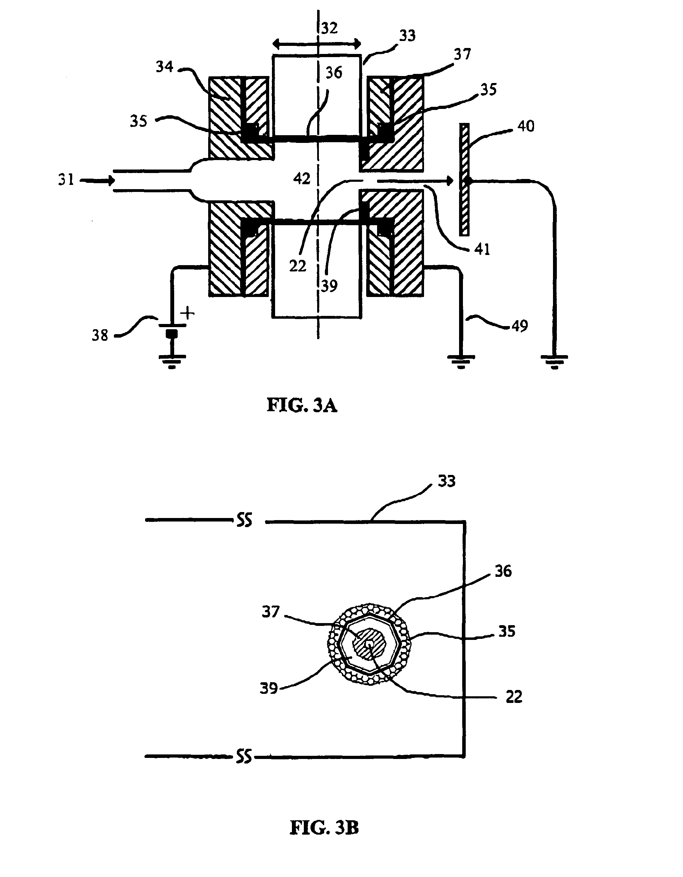

Similar to the method used to produce the pressure difference between the vacuum chamber and the plasma chamber for producing the high-density plasma source mentioned in the above-mentioned article by A. Anders *et al.,* the plasma of the new invention can be energized by means of a sufficiently high microwave filed (2.45 GHz) to ionize the gas molecules so that there are electrons and ions among the neutral atoms. (However, it is hereby emphasized that the role of the microwave is to initialize the plasma, as it will be evident in our invention that after ignition the plasma is maintained by a controlled DC avalanche which affords the ion beam object of the invention.) As shown in **FIG.3A** and **3B** the plasma chamber **36** is a cylindrical tube and made from quartz which can provide a high temperature operation. In addition, while a plasma is produced inside the quartz chamber, any charge that sticks to the wall would repel further approach of other charges of the same kind to effect the plasma's self confinement in accordance with the axial potential distribution. The plasma chamber **36** in this case is installed in the microwave resonant cavity **33** along the width of cavity. At the ends of the plasma chamber, the anode electrode **34** and cathode electrode **37** are installed. The anode electrode is connected to the positive electrode of the dc power supply 38 and the cathode electrode is reference potential of the system, connected to the earth **49**. At the interfaces between the plasma chamber and anode-cathode electrodes, the o-rings **35** are in stalled to prevent gas leakage. Port **31** is the gas inlet. To produce the ion beam for etching applications, argon (Ar) gas is used in providing the ion beam because of the high sputtering yield it can provide. The plasma from the plasma source **42** can be produced in the cylindrical plasma tube **36** (2 centimeter length and 0.8 centimeter inner diameter in one embodiment) by the microwave field **32** whose electric field vector is aligned with the width of the microwave resonant cavity **33.**

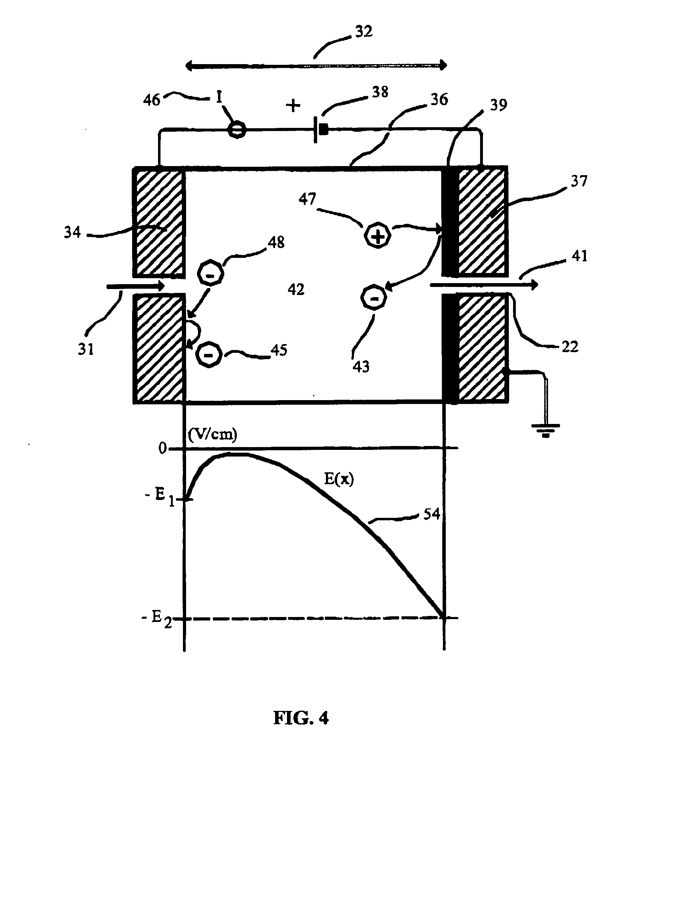

Within the plasma chamber **36,** the plasma from the plasma source **42** which is initiated by the microwave comprises neutral atoms, ions and electrons. Under only the microwave field, the ion movement is negligible compared with the electron' s. Electrons movement at the microwave frequency can acquire sufficient kinetic energy from microwave acceleration so that, upon collision with the neutral atoms would produce ionization. However, in the same microwave field, the positive ion with a mass several thousand times that of the electron is inertially incapable of gaining sufficient kinetic energy to cause ionization of the neutral atom. Therefore "charge carrier generation" or the plasma formation under microwave excitation is mainly caused by the electron's collision with the neutral atoms. When an electron collides with an ion "recombination" may occur which generates radiation and heat, and reduces the plasma density. **FIG. 4** shows the mechanism of the avalanche multiplication of the high current density microwave-initiated ion source. Under both the microwave excitation and a dc bias, the positive ion **47** stream flows in the same direction of the dc electric field to the cathode **37** while the electron **48** flows to the anode **34.** The opposite flow of electron and ion streams cause space charge layers to form with the majority carrier being "negative charge" at the anode and "positive charge" at the cathode respectively, resulting in the narrowing of the neutral plasma (non-space charge) region near the central portion. Such space charge distribution result in opposite slopes of the electric field **54** and provides high electric field at both electrodes. However, due to a much lower mobility of the ions compared to that of the electrons the voltage in the ion space charge is much higher and hence the ions may cause electron **43** ejection from the cathode. Electrons so regenerated are again swept by the dc electric field into the plasma and cause further ionization in the gas, and the cycle is regenerated until a steady state is reached. This additional processes known as "Avalanche Multiplication" occurs when the positive ions **47** impinge on the surface of the cathode material **39** and either transfer their energy to the valence electrons to overcome the work function of the cathode material and can leave the cathode, or presence of the ions on the cathode surface can cause the work function lowering to allow said electrons to tunnel (quantum mechanically) out from the cathode. Therefore the ion-induced secondary electron emission plays an important "feedback" role in avalanche multiplication process which will produce higher conduction charge density in the plasma when the dc electric field at the cathode surface is sufficiently high.

It is now emphasized that our invention is different from that of US 2002/0000779 A1, as the microwave power can be turned off after sufficient avalanche process takes over.

The ion beam current density can be increased by using the cathode which yields a sufficiently high number of secondary electron emission and dc electric field to cause the impact ionization to further increase the number of ions in the space-charge layer. This can be understood from computer simulation, which can demonstrate how the current density can be multiplied, limited and controlled by the various forms of electric field distribution in the gas (e.g., **54**) as shown in Fig. 4.

In summary, the controlling factors for the avalanche multiplication are :
1) The electric field **54** at the surface of surface of cathode **37** must be high enough to allow the ions in space-charge layer near the surface of the cathode to be of higher kinetic energy than the work function of cathode material to yield secondary electrons, and/or
2) The surface of cathode should be of a low work function material conducive to yielding secondary electrons, and must be able to endure ion bombardment.
3) The electric field distribution **54** must be also high enough elsewhere to cause the impact ionization by electrons' collisions with the neutral atoms.

The cathode materials **37** for this invention consist of stainless steel 304 and in one embodiment with a thin aluminum **39** plate on the inner surface of the stainless steel. The aluminum will be provided with an oxide film. The oxide film will provide the proper work function on aluminum for producing more secondary electrons and helps minimize damages from the ion bombardment. Similarly the electrons **48** are driven to the anode and may cause the secondary electrons **45** when the electrons impinge on the anode. However, such secondary electrons **45** will be attracted by the electric field back to the anode and play no further role.

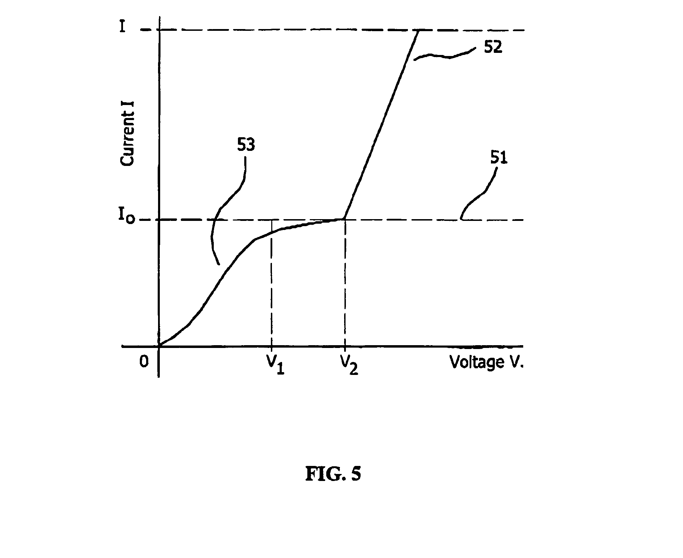

Shown in **FIG. 5****,** is the theoretical relationship between the current **46** and the potential **38** of the high-density microwave-initiated plasma source. In the normal mode when a small bias potential from the power supply **38** is applied to the anode-cathode electrodes the electrons and ions movement are in apposite directions. The space-charge layers of "positive" and "negative" charges are produced at the surface of cathode and anode respectively. The density of electrons and ions within the space-change layers, being factors determining the plasma conductivity, will be a function of the magnitude of the potential. In the region between 0-V1 volt, the current **53** should be proportional to the voltage squared, i.e. I ∝ V², while the conventional plasma source operating in high vacuum, pressure <10⁻⁴ mbar (as in the ECR type ion source), the current would follow the Langmuir-Child Law, i.e. I ∝ V^{3/2}. In the case when avalanche multiplication does not occur, the limited ion density in plasma will cause the current to approach saturation (e.g. **51** in figure 5). But in the case when the cathode can provide secondary electrons the avalanche multiplication occurs from dc and microwave electric fields and causes a "jump" in the value of the current from Io to I at a certain value of voltage V2 seen in graph **52**. The avalanche multiplication is the key mechanism employed in this invention to provide substantially more conduction charge carriers and the resultant high-density ion beam.

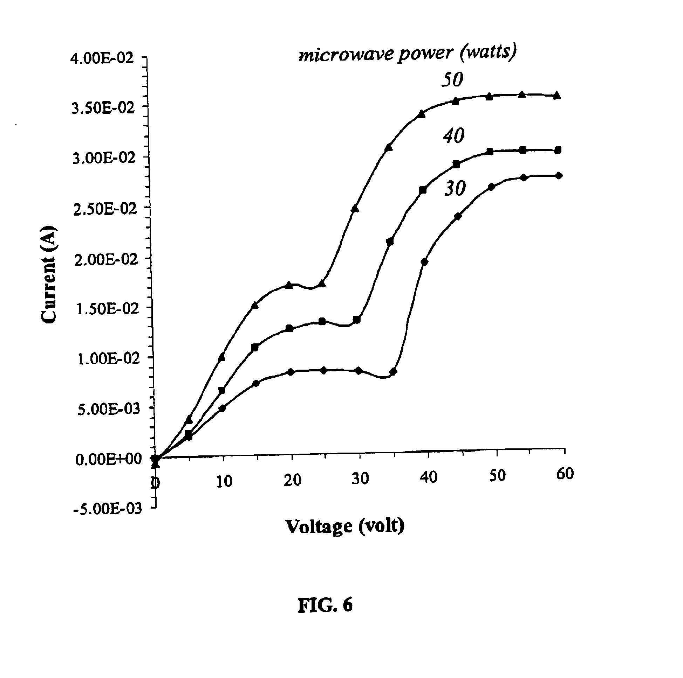

**FIG. 6** is the real experimental data that shows the relationship between the anode-cathode current and voltage of the high-density microwave-initiated plasma source with the microwave power of 30, 40 and 50 watts. The graph indicates the results of the avalanche multiplication that shows the jump in magnitude of the current at different values of the voltage. Note that by using microwave power of 50 watt to ionize the gas the electron and ion densities are higher than those available with the lower power levels of microwave. Therefore, with the higher electron and ion densities the avalanche multiplication can be established and maintained more easily (at the lower voltage DC bias voltages).

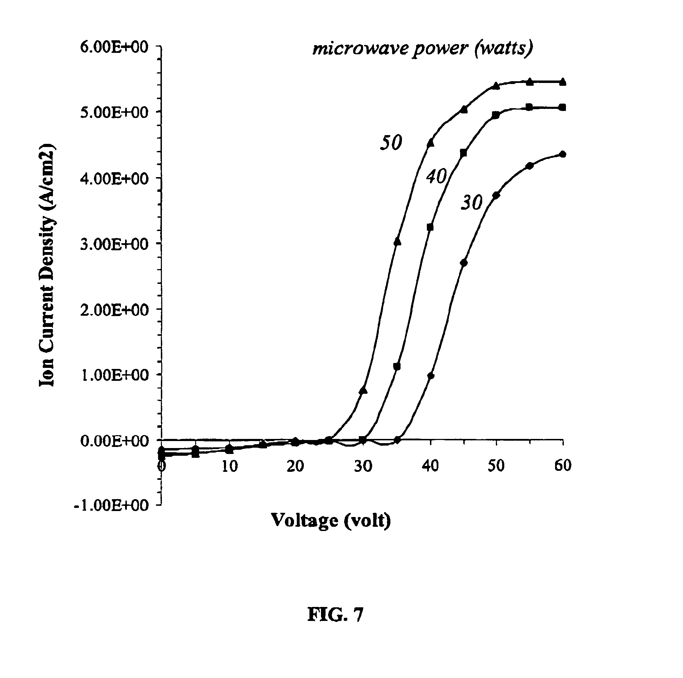

**FIG. 7** shows the relationship between the exit ion beam current density and the potential between the anode and cathode electrodes in the cases initiated by the microwave power 30, 40 and 50 watts. The ions in the space charge layer near the surface of cathode are partly driven by the pressure gradient through the ion exit hole 22 of 500 microns diameter into the vacuum chamber **55**. The ion beam **41** may be collected and measured with the grounded electrode **40** as shown in FIG. 3. The curve in FIG. 7 shows the corresponding relationship between the plasma current density and the values of voltage shown in FIG. 6 regarding the onset of the avalanche. Before the onset of the stable avalanche process the magnitude of ion beam current density is somewhat proportional to microwave power as the sole plasma energizer. This invention can produce sufficient ions from the avalanche process in the 10⁻¹ mbar gas to provide a current density of the orders of several 10 ampere per square centimeter (A/cm²) even when using low power microwave as plasma initiator. A cooling system is therefore not necessary. The produced ion beam will be a low temperature ion beam whose energy spread should be much less than the DC voltage, which in general is less than 50 volt (only a modest DC voltage is needed to cause the avalanche multiplication). Furthermore this invention dose not need a magnetic field for charge confinement. An important accrued advantage of the low energy spread ion source is that when accelerated externally with a high voltage the energy spread remains about the same. The resultant high energy ion beam is thus relatively highly mono-energetic, in contrast to energy spread in an ion beam "pulled" directly from the plasma by the high voltage.

Use of the Invention:
As a low cost ion-beam source capable of producing high intensity an ion beam of arbitrarily high energy with very small energy spread and low beam divergence the invention will find applications requiring high resolution patterning such as etching and ion-implantation in the micro designing of various materials and devices. Most importantly such patterning can be achieved in three dimensions, and thus opening up new frontier of development.

Best Method of the Invention:
1) The suitable cathode material should be able to sustain the bombardment by the ions in order to have long useful life, and must be able to provide appreciable secondary electrons from said bombardment. Said material may require special processing such as anodization in the case of aluminum.
2) To effect the low beam divergence the exit hole of the plasma chamber is to function like a gun barrel, namely the length should be at least ten times the hole's diameter while the latter must be sufficiently small compared to the cathode's total area to maintain sufficient pressure difference between inside the plasma chamber and the external vacuum.
3) The length of the plasma chamber should be as short as possible to allow control of the plasma by a small DC voltage in order to minimize the power needed and eliminate the need for temperature control.
4) The plasma initiation mechanism may best be a voltage pulse but this may shorten the cathode's life. For the latter a microwave or a laser igniter may serve better, depending on which configuration is most suitable for a particular application.

## Claims

1. A high current density ion beam source comprising a cylindrical plasma chamber (36) made from an electrically non-conductive tube and connected to a vacuum chamber (55), the plasma chamber comprising:
- a cathode electrode (21, 37) having an ion exit hole (22),
- an anode electrode (34) made from an electrically conductive material, having a hole for a gas inlet (31) into the plasma chamber,
- a plasma initiating mechanism (33) to initiate a plasma within the plasma chamber, and
- a DC voltage source (38) connected to the cathode and anode electrode, respectively, to maintain an avalanche multiplication within the plasma,
**characterized in that** the plasma initiating mechanism (33) is designed for being turned off after initiating an avalanche process in the plasma, and that the surface of the cathode electrode (21, 37) is able to endure bombardment by ions of energies of the order of the ionization energy of the gas, and is made of a material of low work function conducive to yielding ion-induced secondary electrons emission.

2. The high current density ion source according to Claim 1 wherein the plasma chamber is made of quartz.

3. The high current density ion source according to Claim 1 or 2, adapted to maintain the pressure in the plasma chamber (36) to be in the range of 10^{-1±1} mbar by balancing the out-flow of the gas inside the plasma chamber through the ion exit hole (22) into the vacuum chamber with the input flow from the gas inlet (31).

4. The high current density ion source according to Claim 3, wherein the gas is argon with a pressure in the plasma chamber near 0.1 mbar.

5. The high current density ion source according to Claim 3, wherein the diameter of the chamber is at least 5 times longer than the mean free path of the gas atoms at the pressure maintained upon operation in the plasma chamber (36).

6. The high current density ion source according to any of the above Claims wherein the ratio of the chamber's diameter to the exit hole's diameter is not less than 10, preferably 10 or slightly larger.

7. The high current density ion source of Claim 1 wherein the cathode electrode is built from an electrically conductive material, the inside-facing area of which is installed with a special material whose thickness and property are adapted to allow the exit of the electrons in the cathode material into the plasma chamber if the surface is sufficiently positively charged.

8. The high current density ion source of Claim 7 wherein the special material is in the form of thin films in the order of 2-20 nm.

9. The high current density ion source of Claim 7 wherein the special material is in the form of oxide film of aluminum made by being processed through anodization.

10. The high current density ion source of Claim 1 wherein the cathode electrode has a hole, preferably round hole, to serve as an exit hole of an ion stream from the plasma chamber into the vacuum chamber.

11. The high current density ion source of Claim 1 wherein the cathode electrode acts as the reference potential of the system and is connected to the ground.

12. The high current density ion source of Claim 1 wherein the anode electrode has a hole to serve as a gas inlet port, which is connected to an equipment adapted to control the flow rate of gas into the plasma tube.

13. The high current density ion source of Claim 1 wherein the DC voltage source is adapted to sustain the avalanche multiplication with a voltage of 50 V or less.

14. The high current density ion source of Claim 1 wherein the plasma initiating mechanism comprises a microwave resonance cavity (33), wherein the plasma chamber is installed in the microwave resonance cavity and aligned with the width (32) of the microwave resonance cavity.

15. The high current density ion source of Claim 14, adapted to be used with a microwave power of less than 50 W.

16. The high current density ion source of Claim 14 wherein inside the microwave resonance cavity is a microwave antenna, which is connected to a microwave source of 2.45 GHz frequency, used to propagate the microwave field into the microwave cavity.

17. The high current density ion source of Claim 1 wherein the plasma initiating mechanism is an equipment to initiate a pulse voltage in the plasma chamber.

18. The high current density ion source of Claim 1, adapted to establish upon operation a pressure gradient between the plasma chamber and the vacuum chamber, such that
after initiation of avalanche multiplication, the mechanism of the DC avalanche multiplication sustains a high current density by making use of said pressure gradient.

19. The high current density ion source of Claim 1, comprising means to further externally accelerate ions to an arbitrary high energy while maintaining the low beam divergence and low energy spread.

20. The high current density ion source according to Claim 1, wherein the vacuum chamber (55) connected to the plasma chamber (36) has a vacuum of the order of 10⁻⁴ mbar or lower.

21. The high current density ion source according to Claim 1, comprising means (35) for preventing gas leakage between the tube of the plasma chamber (36) and the anode and cathode electrodes.

## Patentansprüche

1. Quelle für einen Ionenstrahl hoher Stromdichte, mit einer mit einer Vakuumkammer (55) verbundenen zylindrischen Plasmakammer (36) aus einem elektrisch nichtleitenden Rohr, wobei die Plasmakammer aufweist:
- eine Kathodenelektrode (21, 37) mit einer Ionenaustrittsöffnung (22),
- eine Anodenelektrode (34) aus einem elektrisch leitenden Material, mit einer Öffnung für einen Gaseinlass (31) in die Plasmakammer,
- einen Plasmazündmechanismus (33) zum Initiieren eines Plasmas in der Plasmakammer, und
- eine Gleichspannungsquelle (38), die jeweils mit der Kathoden- und Anodenelektrode verbunden ist, um eine Lawinenvervielfachung im Plasma aufrecht zu erhalten,
**dadurch gekennzeichnet, dass**
der Plasmazündmechanismus (33) dazu eingerichtet ist, nach der Initiierung eines Lawinenprozesses im Plasma abgeschaltet zu werden, und dass die Oberfläche der Kathodenelektrode (21, 37) dazu geeignet ist, ein Bombardement mit Ionen von Energien der Ordnung der Ionisierungsenergie des Gases zu überstehen, und aus einem für die ioneninduzierte Sekundärelektronen-Emission zuträglichen Material niedriger Austrittsarbeit besteht.

2. Ionenstrahlquelle hoher Stromdichte nach Anspruch 1, bei welcher die Plasmakammer aus Quarz besteht.

3. lonenstrahlquelle hoher Stromdichte nach Anspruch 1 oder 2, dazu ausgelegt, den Druck in der Plasmakammer (36) in einem Bereich von 10^{-1±1} mbar durch Ausbalancieren des Auswärtsflusses des Gases in der Plasmakammer durch die Ionenaustrittsöffnung (22) in die Vakuumkammer mit dem Eingangsfluss aus dem Gaseinlass (31) zu halten.

4. Ionenstrahlquelle hoher Stromdichte nach Anspruch 3, bei welcher das Gas Argon mit einem Druck in der Plasmakammer nahe 0,1 mbar ist.

5. Ionenstrahlquelle hoher Stromdichte nach Anspruch 3, bei welcher der Durchmesser der Kammer zumindest 5mal länger ist als die mittlere freie Weglänge der Gasatome bei dem in der Plasmakammer bei Betrieb aufrecht gehaltenen Druck.

6. Ionenstrahlquelle hoher Stromdichte nach einem der obigen Ansprüche, bei welcher das Verhältnis des Kammerdurchmessers zum Durchmesser der Austrittsöffnung bei nicht unter 10, vorzugsweise 10 oder geringfügig größer, liegt.

7. Ionenstrahlquelle hoher Stromdichte nach Anspruch 1, bei welcher die Kathodenelektrode aus einem elektrisch leitenden Material gefertigt ist, dessen nach innen gerichtete Fläche mit einem speziellen Material ausgestattet ist, dessen Dicke und Eigenschaften dazu ausgelegt sind, den Austritt von Elektronen im Kathodenmaterial in die Plasmakammer zu ermöglichen, wenn die Oberfläche ausreichend positiv geladen ist.

8. Ionenstrahlquelle hoher Stromdichte nach Anspruch 7, bei welcher das spezielle Material als dünne Filme in der Ordnung von 2-20 nm ausgebildet ist.

9. Ionenstrahlquelle hoher Stromdichte nach Anspruch 7, bei welcher das spezielle Material als mittels Prozessieren durch Anodisieren erzeugter Aluminium-Oxid-Film ausgebildet ist.

10. Ionenstrahlquelle hoher Stromdichte nach Anspruch 1, bei welcher die Kathodenelektrode eine Öffnung, vorzugsweise eine runde Öffnung, aufweist, um als Austrittsöffnung eines Ionenstrahls aus der Plasmakammer in die Vakuumkammer zu dienen.

11. Ionenstrahlquelle hoher Stromdichte nach Anspruch 1, bei welcher die Kathodenelektrode als Referenzpotential des Systems fungiert und mit Masse verbunden ist.

12. Ionenstrahlquelle hoher Stromdichte nach Anspruch 1, bei welcher die Anodenelektrode eine als Gaseinlassmündung dienende Öffnung hat, die mit einer zum Steuern der Flussmenge des Gases in das Plasmarohr ausgelegten Einrichtung verbunden ist.

13. Ionenstrahlquelle hoher Stromdichte nach Anspruch 1, bei welcher die Gleichspannungsquelle dazu ausgelegt ist, die Lawinenvervielfachung bei einer Spannung von 50 V oder darunter aufrecht zu halten.

14. Ionenstrahlquelle hoher Stromdichte nach Anspruch 1, bei welcher der Plasmazündmechanismus einen Mikrowellenresonanzhohlraum (33) aufweist, wobei die Plasmakammer in dem Mikrowellenresonanzhohlraum angeordnet ist und mit der Weite des Mikrowellenresonanzhohlraums ausgerichtet ist.

15. Ionenstrahlquelle hoher Stromdichte nach Anspruch 14, ausgelegt zur Verwendung bei einer Mikrowellenleistung unter 50 W.

16. Ionenstrahlquelle hoher Stromdichte nach Anspruch 14, bei welcher sich in dem Mikrowellenresonanzhohlraum eine Mikrowellenantenne befindet, die mit einer Mikrowellenquelle der Frequenz 2,45 GHz verbunden und zur Ausbreitung des Mikrowellenfelds in den Mikrowellenhohlraum verwendbar ist.

17. Ionenstrahlquelle hoher Stromdichte nach Anspruch 1, bei welcher der Plasmazündmechanismus eine Einrichtung zum Initiieren eines Spannungspulses in der Plasmakammer ist.

18. Ionenstrahlquelle hoher Stromdichte nach Anspruch 1, dazu ausgelegt, bei Betrieb einen Druckgradienten zwischen der Plasmakammer und der Vakuumkammer aufzubauen, wobei nach Initiierung der Lawinenvervielfachung der Mechanismus der Gleichstromlawinenvervielfachung eine hohe Stromdichte unter Ausnutzung des Druckgradienten aufrecht haltbar ist.

19. Ionenstrahlquelle hoher Stromdichte nach Anspruch 1, mit Mitteln zum weiteren externen Beschleunigen von Ionen auf eine beliebige hohe Energie unter Beibehaltung der geringen Strahldivergenz und niedrigen Energiebreite.

20. Ionenstrahlquelle hoher Stromdichte nach Anspruch 1, bei welcher die mit der Plasmakammer (36) verbundene Vakuumkammer (55) ein Vakuum der Ordnung 10⁻⁴ mbar oder darunter hat.

21. Ionenstrahlquelle hoher Stromdichte nach Anspruch 1, mit Mitteln (35) zum Verhindern von Gaslecks zwischen dem Rohr der Plasmakammer (36) und der Anoden- und Kathodenelektroden.

## Revendications

1. Source de faisceau d'ions à densité de courant élevée, comprenant une chambre cylindrique à plasma (36) composée d'un tube électriquement non conducteur et connectée à une chambre à vide (55), la chambre à plasma comprenant :
- une électrode de cathode (21, 37) dotée d'un orifice de sortie d'ions (22),
- une électrode d'anode (34) composée d'un matériau électriquement conducteur, dotée d'un orifice permettant l'entrée d'un gaz (31) dans la chambre à plasma,
- un mécanisme d'initiation de plasma (33) pour initier un plasma au sein de la chambre à plasma, et
- une source de tension en CC (38) connectée respectivement à l'électrode de cathode et à l'électrode d'anode pour entretenir une multiplication par avalanche au sein du plasma,
**caractérisée en ce que** le mécanisme d'initiation de plasma (33) est conçu pour s'arrêter après l'initiation d'un processus d'avalanche dans le plasma, et **en ce que** la surface de l'électrode de cathode (21, 37) est capable de supporter un bombardement d'ions ayant des énergies de l'ordre de l'énergie d'ionisation du gaz et est composée d'un matériau présentant un faible travail d'extraction permettant la formation d'une émission d'électrons secondaires induite par les ions.

2. Source d'ions à densité de courant élevée selon la revendication 1, dans laquelle la chambre à plasma est composée de quartz.

3. Source d'ions à densité de courant élevée selon la revendication 1 ou 2, capable de maintenir la pression dans la chambre à plasma (36) dans la plage allant de 10^{-1 ± 1} mbar en équilibrant le flux de sortie du gaz se trouvant dans la chambre à plasma par l'orifice de sortie d'ions (22) dans la chambre à vide avec le flux d'entrée provenant de l'entrée de gaz (31).

4. Source d'ions à densité de courant élevée selon la revendication 3, dans laquelle le gaz est de l'argon à une pression dans la chambre à plasma proche de 0,1 mbar.

5. Source d'ions à densité de courant élevée selon la revendication 3, dans laquelle le diamètre de la chambre est au moins 5 fois plus long que le libre parcours moyen des atomes de gaz à la pression maintenue lors du fonctionnement dans la chambre à plasma (36).

6. Source d'ions à densité de courant élevée selon l'une quelconque des revendications précédentes, dans laquelle le rapport entre le diamètre de la chambre et le diamètre de l'orifice de sortie n'est pas inférieur à 10, et est de préférence de 10 ou légèrement supérieur.

7. Source d'ions à densité de courant élevée selon la revendication 1, dans laquelle l'électrode de cathode est construite à partir d'un matériau électriquement conducteur, sa partie orientée vers l'intérieur étant installée avec un matériau spécial dont l'épaisseur et la propriété sont capables de permettre la sortie des électrons se trouvant dans le matériau de cathode dans la chambre à plasma si la surface est suffisamment positivement chargée.

8. Source d'ions à densité de courant élevée selon la revendication 7, dans laquelle le matériau spécial est sous la forme de films minces de l'ordre de 2 nm à 20 nm.

9. Source d'ions à densité de courant élevée selon la revendication 7, dans laquelle le matériau spécial est sous la forme d'un film d'oxyde d'aluminium préparé en étant traité par anodisation.

10. Source d'ions à densité de courant élevée selon la revendication 1, dans laquelle l'électrode de cathode possède un orifice, de préférence un orifice rond, servant d'orifice de sortie pour un courant ionique provenant de la chambre à plasma pour aller dans la chambre à vide.

11. Source d'ions à densité de courant élevée selon la revendication 1, dans laquelle l'électrode de cathode joue le rôle de potentiel de référence du système et est connectée à la terre.

12. Source d'ions à densité de courant élevée selon la revendication 1, dans laquelle l'électrode d'anode possède un orifice servant d'orifice d'entrée de gaz, qui est connecté à un équipement capable de réguler le débit du gaz dans le tube à plasma.

13. Source d'ions à densité de courant élevée selon la revendication 1, dans laquelle la source de tension en CC est capable d'entretenir la multiplication par avalanche avec une tension inférieure ou égale à 50 V.

14. Source d'ions à densité de courant élevée selon la revendication 1, dans laquelle le mécanisme d'initiation de plasma comprend une cavité résonante micro-onde (33), la chambre à plasma étant installée dans la cavité résonante micro-onde et alignée avec la largeur (32) de la cavité résonante micro-onde.

15. Source d'ions à densité de courant élevée selon la revendication 14, pouvant être utilisée avec une puissance micro-onde inférieure à 50 W.

16. Source d'ions à densité de courant élevée selon la revendication 14, dans laquelle, à l'intérieur de la cavité résonante micro-onde, se trouve une antenne à micro-ondes qui est connectée à une source micro-onde ayant une fréquence de 2,45 GHz, utilisée pour propager le champ micro-onde dans la cavité micro-onde.

17. Source d'ions à densité de courant élevée selon la revendication 1, dans laquelle le mécanisme d'initiation de plasma est un équipement permettant d'initier une impulsion de tension dans la chambre à plasma.

18. Source d'ions à densité de courant élevée selon la revendication 1, capable d'établir lors du fonctionnement un gradient de pression entre la chambre à plasma et la chambre à vide, de sorte qu'après l'initiation de la multiplication par avalanche, le mécanisme de la multiplication par avalanche en CC entretient une densité de courant élevée au moyen dudit gradient de pression.

19. Source d'ions à densité de courant élevée selon la revendication 1, comprenant un moyen pour accélérer davantage à l'extérieur les ions jusqu'à une énergie élevée arbitraire tout en conservant la faible divergence du faisceau et le faible étalement d'énergie.

20. Source d'ions à densité de courant élevée selon la revendication 1, dans laquelle la chambre à vide (55) connectée à la chambre à plasma (36) présente un vide de l'ordre de 10⁻⁴ mbar ou moins.

21. Source d'ions à densité de courant élevée selon la revendication 1, comprenant un moyen (35) pour empêcher une fuite de gaz entre le tube de la chambre à plasma (36) et les électrodes d'anode et de cathode.
